# EUROPEAN PATENT APPLICATION

(11) **EP 4 810 973 A1**
(43) Date of publication of application: **23.09.2026**
(21) Application number: 26165805.8
(22) Date of filing: 18.03.2026
(51) Int. Cl.: G01R 31/34

(54) **BRUSH HOLDER AND BRUSH HOLDER RIGGING INCLUDING SAME**

(30) Priority: 21.03.2025 KR 20250036833
(71) Applicant: Doosan Enerbility Co., Ltd., Seongsan-gu Changwon-si, Gyeongsangnam-do 51711 (KR)
(72) Inventor: HWANG, Kyeha, 51019 Changwon-si (KR); LEE, Wanjoo, 51470 Changwon-si (KR)
(74) Representative: Ter Meer Steinmeister & Partner

(57) **Abstract**

Proposed are a brush holder and a brush holder rigging including the brush holder. More particularly, proposed are a brush holder capable of measuring an amount of current flowing through a brush, and a brush holder rigging including the brush holder. In the brush holder, a magnetic field sensor may measure a magnetic field of a terminal bar connected to the brush. In addition, the controller may calculate the amount of current through the brush on the basis of the measured magnetic field.

## Description

### BACKGROUND OF THE INVENTION

### 1. Field of the Invention

The present disclosure relates to a brush holder and a brush holder rigging including the brush holder. More particularly, the present disclosure relates to a brush holder capable of measuring an amount of current flowing through a brush, and a brush holder rigging including the brush holder.

### 2. Description of the Background Art

A brush holder rigging (BHR) (also referred to as a generator excitation current supply apparatus) is an apparatus for supplying current from an external exciter to a collector ring of a generator. The current supplied from the exciter may be sequentially transferred to a busbar and a brush holder. In addition, the current may be transferred from the brush to the collector ring through friction between the brush and the collector ring.

The brush may be gradually worn and thus shortened in length by continuous friction caused by the rotation of a rotor, which may result in an increase in frictional heat. In addition, the temperature of the brush may further increase due to heat generated by current flowing through the brush.

When a brush becomes shortened beyond an acceptable limit, it may no longer properly perform transfer of current, which leads to an increase in the current flowing through other brushes. If this condition is repeated and continues, the amount of current flowing through the remaining brushes may progressively increases, leading to excessive increase in temperature that may potentially result in serious accidents, such as a fire.

Therefore, it is desirable to monitor the condition of the brush by measuring the amount of current flowing through each brush. However, because the magnitude of the current flowing through the brush is substantially high, there is a significant risk of electric shock if an operator directly contacts a current measurement device to measure the amount of current.

In addition, in the brush holder rigging, available installation space is limited. Therefore, there is a spatial constraint that make it difficult to additionally install a separate device dedicated to measuring the amount of current flowing through the brush.

The foregoing is intended merely to aid in the understanding of the background of the present disclosure, and is not intended to mean that the present disclosure falls within the purview of the related art that is already known to those skilled in the art.

### SUMMARY OF THE INVENTION

The present disclosure is directed to providing a brush holder capable of measuring an amount of current flowing through a brush, and a brush holder rigging including the brush holder.

According to an embodiment of the present disclosure, there is provided a brush holder including a body, a connection part, a magnetic field sensor, and a controller. A lower side of the brush may be configured to mount a brush. The connection part may be operable to connect the body to the brush to transfer current from the body to the brush. The magnetic field sensor may be installed at the connection part to measure a magnetic field of the connection part. The controller may be configured to calculate an amount of current flowing through the brush based on a measurement value of the magnetic field sensor.

According to an embodiment of the present disclosure, the controller may be configured to transmit, to an external terminal, the measurement value of the magnetic field sensor or the amount of current.

According to an embodiment of the present disclosure, the connection part may include a terminal bar and an electric wire. An upper portion of the terminal bar may be installed at the body, and the magnetic field sensor may be disposed at a side surface of the terminal bar. The electric wire may be installed at a lower portion of the terminal bar and configured to be connected to the brush.

According to an embodiment of the present disclosure, the brush holder may further include a sensor housing and a shielding plate. The sensor housing may be installed at the terminal bar so that the magnetic field sensor may be disposed inside the sensor housing. The shielding plate may be installed at the sensor housing.

According to an embodiment of the present disclosure, the housing cover may be further included. The housing cover may be detachably coupled with the sensor housing.

According to an embodiment of the present disclosure, the housing cover may be coupled to opposite side ends of the sensor housing to face the magnetic field sensor.

According to an embodiment of the present disclosure, the shielding plate may be installed at an inner side surface of and along a circumference of the sensor housing to surround the terminal bar.

According to an embodiment of the present disclosure, a plate insertion groove may be formed in an inner side surface of the sensor housing so that the shielding plate may be inserted into the plate insertion groove.

According to an embodiment of the present disclosure, hook protrusions may be formed at opposite side ends of the sensor housing to be coupled to the housing cover.

According to an embodiment of the present disclosure, handle protrusions may be formed at opposite side ends of the housing cover.

According to an embodiment of the present disclosure, slide grooves may be formed extending in a vertical direction at opposite side ends of the sensor housing, and coupling protrusions may be formed extending in the vertical direction at opposite side ends of the housing cover to be inserted into the slide grooves.

According to an embodiment of the present disclosure, support protrusions may be formed at opposite side ends of the sensor housing to be in contact with a lower end of the housing cover.

According to an embodiment of the present disclosure, the brush holder may further include a body cover. The body cover may be installed at the body to cover the electric wire.

According to an embodiment of the present disclosure, at a side surface of the body cover, a plurality of partition walls may be formed spaced apart from each other. The electric wire may include a plurality of wires. Each of the plurality of electric wires may be disposed between two adjacent partition walls such that the plurality of partition walls separates each wire from other wires.

According to an embodiment of the present disclosure, the brush holder may further include a controller housing. The controller housing may be installed at an upper portion of the body so that the controller may be disposed inside the controller housing.

According to an embodiment of the present disclosure, there is provided a brush holder rigging including a rotor, a collector ring, a busbar, a brush, and a brush holder. The collector ring may be penetrated by the rotor for power generation and fixed to the rotor. The busbar may be penetrated by the collector ring. The brush may be in contact with the collector ring. The brush may be installed at the brush holder and the brush holder may be coupled to the busbar.

In the brush holder and the brush holder rigging including the brush holder according to an embodiment of the present disclosure, the magnetic field sensor can measure a magnetic field of the terminal bar connected to the brush. In addition, the controller can calculate the amount of current through the brush on the basis of the measured magnetic field.

Accordingly, the amount of current can be precisely measured for each brush so that an error range of the amount of current can be reduced. In addition, the amount of current can be measured without a manager directly touching the brush, thereby eliminating a possibility of an electric shock accident.

In addition, the controller can transmit the calculated amount of current to the manager's terminal so that the manager can monitor the state of the brush in real time. The manager can monitor the brush to selectively determine whether to replace the brush or whether to operate a generator.

In addition, the terminal bar, the electric wire, and the magnetic field sensor can be installed at the brush holder so that there is no need to secure a separate space in the brush holder rigging. Accordingly, it can be applied to a brush holder rigging designed in the related art, so that business scalability can be expected.

### BRIEF DESCRIPTION OF THE DRAWINGS

FIG. 1 is a side view of a brush holder rigging;
FIG. 2 is a cross-sectional view of the brush holder rigging;
FIG. 3 is a perspective view of a first side of a brush holder according to an embodiment of the present disclosure;
FIG. 4 is a perspective view of a second side of the brush holder;
FIG. 5 is a perspective view showing a state in which a body cover is separated from the brush holder;
FIG. 6 is a perspective view of a body;
FIG. 7 is a perspective view showing a state in which a housing cover is separated from a sensor housing;
FIGS. 8A and 8B are perspective views showing a first embodiment of a sensor housing and a state in which a shielding plate is separated from the sensor housing;
FIGS. 9A and 9B are perspective views showing a second embodiment of a sensor housing and a state in which the housing cover is separated from the sensor housing;
FIG. 10 is a sectional view taken along line B-B shown in FIG. 3;
FIG. 11 is a perspective view showing a state in which a sensor block and a brush are lowered;
FIG. 12 is an enlarged view of portion B shown in FIG. 10;
FIGS. 13A and 13B are perspective views showing a first side surface and a second side surface of the sensor block;
FIG. 14 is a perspective view showing a first side of a plurality of sensor blocks and brushes;
FIG. 15 is a perspective view showing a second side of the plurality of sensor blocks and brushes;
FIGS. 16A to 16C are perspective views showing a first side surface, a rear surface, and a second side surface of a single sensor block and a single brush;
FIG. 17 is a perspective view showing a state in which a wiring duct is separated from a partition plate;
FIG. 18 is a sectional view taken along line A-A shown in FIG. 3;
FIG. 19 is an enlarged view of portion A shown in FIG. 18;
FIG. 20 is a side view showing a state in which the brush is fixed to a hook member;
FIG. 21 is a side view showing a state in which the brush is separated from the hook member; and
FIGS. 22A and 22B are schematic cross-sectional views showing an elevating part in the brush holder according to a second embodiment of the present disclosure and a state in which a guide pin is raised.

### DETAILED DESCRIPTION OF THE INVENTION

The present disclosure may be modified in various ways and may have various embodiments, and specific embodiments will be illustrated and described in detail. However, the present disclosure is not limited thereto, and it should be understood that the exemplary embodiments include all modifications, equivalents, or substitutes in the idea and the technical scope of the present disclosure.

The terms used in the present disclosure are merely used to describe the specific embodiments, and are not intended to limit the present disclosure. As used herein, the singular forms "a", "an", and "the" are intended to include the plural forms as well, unless the context clearly indicates otherwise. In the present disclosure, it is to be understood that terms such as "including", "having", etc. are intended to indicate the existence of the features, numbers, steps, actions, elements, parts, or combinations thereof disclosed in the specification, and are not intended to preclude the possibility that one or more other features, numbers, steps, actions, elements, parts, or combinations thereof may exist or may be added.

Hereinafter, exemplary embodiments of the present disclosure will be described in detail with reference to the drawings. Herein, it is noted that the same reference numerals designate the same elements throughout the drawings. In addition, a detailed description of known functions and configurations that make the subject matter of the present disclosure unclear will be omitted. For the same reason, some elements may be exaggerated, omitted, or roughly illustrated in the accompanying drawings.

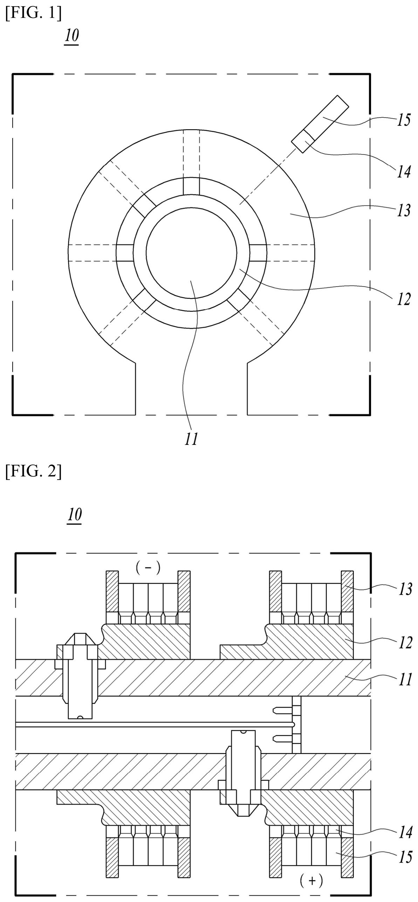

FIG. 1 is a side view of a brush holder rigging according to an embodiment of the present disclosure. FIG. 2 is a cross-sectional view of the brush holder rigging.

As shown in FIGS. 1 and 2, a brush holder rigging 10 may include a collector ring 12, a busbar 13, a brush 14, and a brush holder 15. The collector ring 12 may be penetrated by the rotor 11 and be fixed to the rotor 11.

The busbar 13 may be formed in a ring shape. The busbar 13 may be penetrated by the collector ring 12. The brush 14 may be made of a carbon material. The brush 14 may be in contact with an outer circumferential surface of the collector ring 12.

The brush holder 15 may have a plurality of brushes 14 arranged in a line and fixed thereto. In addition, a plurality of brush holders 15 may be provided and spaced apart from each other along a circumferential direction of the busbar 13 and may be coupled to or separated from the busbar 13.

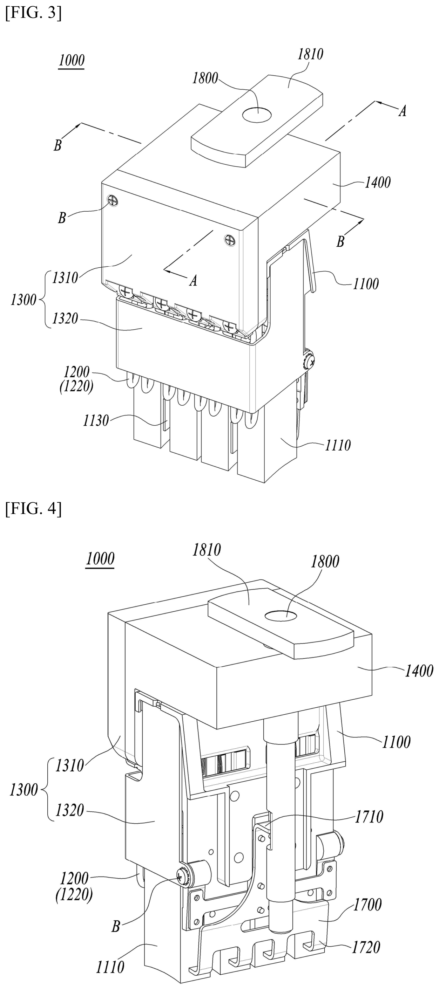

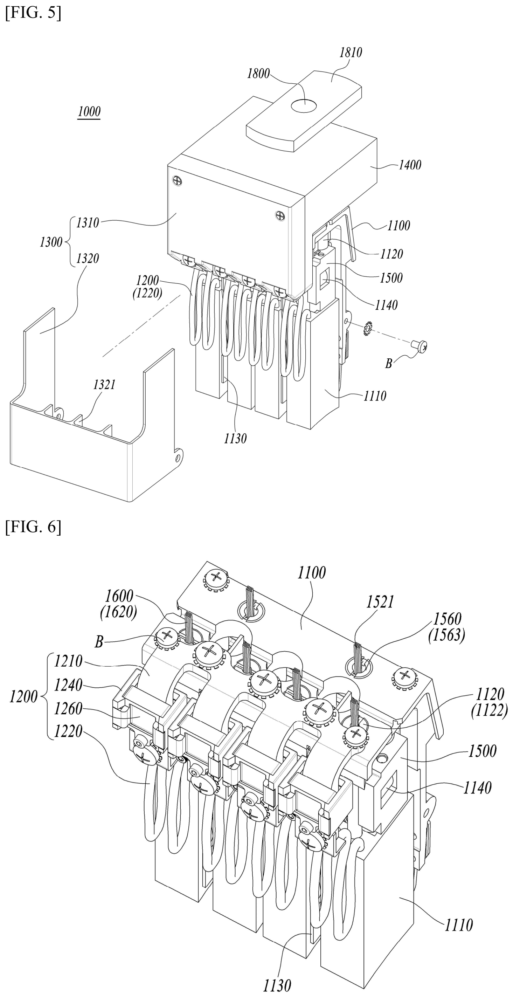

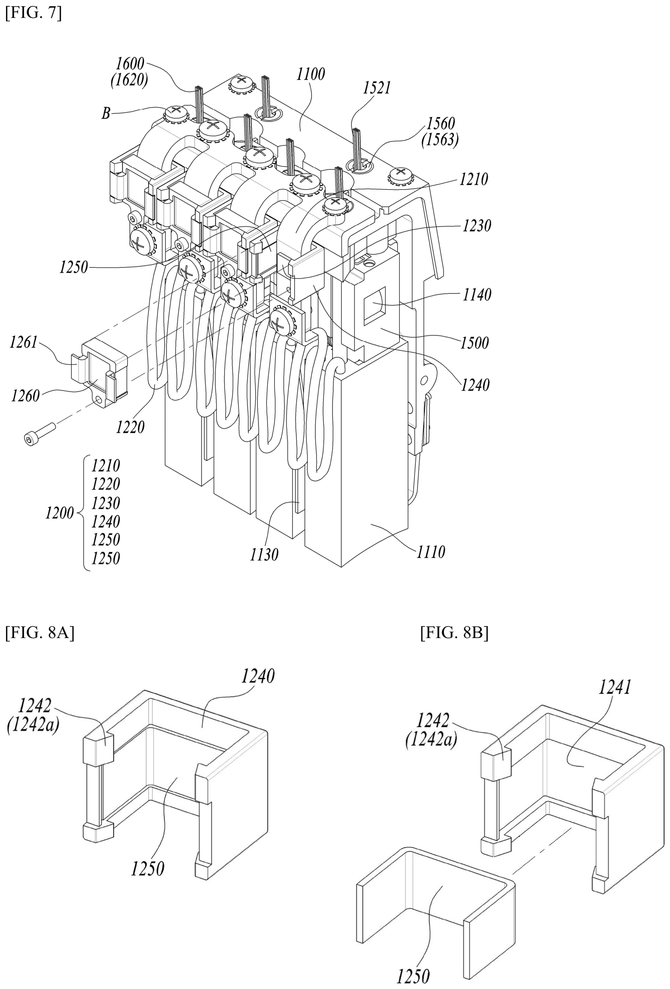

FIG. 3 is a perspective view of a first side of a brush holder according to an embodiment of the present disclosure. FIG. 4 is a perspective view of a second side of the brush holder. FIG. 5 is a perspective view showing a state in which a body cover is separated from the brush holder. FIG. 6 is a perspective view of a body. FIG. 7 is a perspective view showing a state in which a housing cover is separated from a sensor housing.

As shown in FIGS. 3 to 7, the brush holder 1000 may be made of a known material, such as metal, through which current may flow. According to an embodiment, the brush holder 1000 may include a body 1100, a connection part 1200, a magnetic field sensor 1230, a body cover 1300, and a controller.

The body 1100 may be coupled to the busbar 13 (shown in FIG. 2) such that current may be transmitted from the busbar 13 to the body 1100. The body 1100 may be formed in an upside-down L-shape. A plurality of brushes 1110 may be provided and arranged in a line at a lower side of the body 1100.

According to an embodiment, a horizontal cross-section of each of the plurality of brushes 1110 may have a rectangular shape. A shorter side of the rectangular horizontal cross-section of each brush 1110 may be defined as a width, and a direction parallel to the width may be defined as a width direction. A longer side of the rectangular horizontal cross-section of each brush 1110 may be defined as a breadth, and a direction parallel to the breadth may be defined as a breadth direction. According to an embodiment, the plurality of brushes 1110 may be arranged along the width direction.

A direction extending from the brushes 1110 toward the collector ring 12 and the rotor 11 may be defined as an upward-downward direction or a vertical direction.

The connection part 1200 may be disposed between the body 1100 and the brush 1110 to transfer current from the body 1100 to the brush 1110.

According to an embodiment, the magnetic field sensor 1230 may be installed at the connection part 1200 to measure a magnetic field generated by the connection part 1200, more specifically, a terminal bar 1210, which will be described later.

The controller may calculate an amount of current flowing through the brush 1110 based on a measurement value of the magnetic field sensor 1230. A known algorithm for calculating the amount of current from the magnetic field may be stored in the controller.

Accordingly, the amount of current may be precisely measured for each brush 1110, thereby reducing an error range in the current measurement. In addition, the amount of current may be measured without a manager directly touching the brush 1110, thereby reducing a risk of an electric shock accident.

According to an embodiment, the controller may be connected to a manager terminal (e.g., a smartphone or a PC) in a wireless or wired manner. The controller may transmit the calculated amount of current to the manager terminal so that the manager may monitor the state of the brush 1110 in real time.

The manager may monitor the brush 1110, and when a particular brush exceeds a predetermined temperature range, may selectively determine whether to replace the brush and/or whether to operate the generator.

According to an embodiment, the connection part 1200 may include the terminal bar 1210, and an electric wire 1220. The terminal bar 1210 and the electric wire 1220 may be provided for each brush 1110. An upper end of the terminal bar 1210 may be fixed to an upper surface of the body 1100.

According to an embodiment, the magnetic field sensor 1230 may be disposed on and fixed to a side surface of the terminal bar 1210. The electric wire 1220 may be connected between a lower end of the terminal bar 1210 and an upper end of the brush 1110.

According to an embodiment, fixing of the connection part 1200 may be achieved via a known fixing member such as a bolt or a screw or a welding method. Such fixing methods may likewise be applied to connections between other elements constituting the brush holder 1000, and a redundant description thereof are omitted for brevity.

According to an embodiment, the body cover 1300 may include an upper portion cover 1310 and a lower portion cover 1320. The upper portion cover 1310 may be fixed to a controller housing 1400 to cover and protect the controller housing 1400 and the terminal bar 1210. The lower portion cover 1320 may be fixed to the body 1100 to cover and protect the electric wire 1220 and a side surface of the brush 1110.

According to an embodiment, at a side surface of the body cover 1300, a plurality of partition walls 1321 (shown in FIG. 5) may be formed so as to be spaced apart from each other. The electric wire 1220 may be disposed between the adjacent partition walls 1321. That is, the electric wires 1220 corresponding to the respective brushes 1110 may be physically separated from one another by the partition walls 1321. Accordingly, unintended contact between the adjacent electric wires 1220 may be prevented, thereby reducing overcurrent from flowing through the brushes 1110 due to such contact.

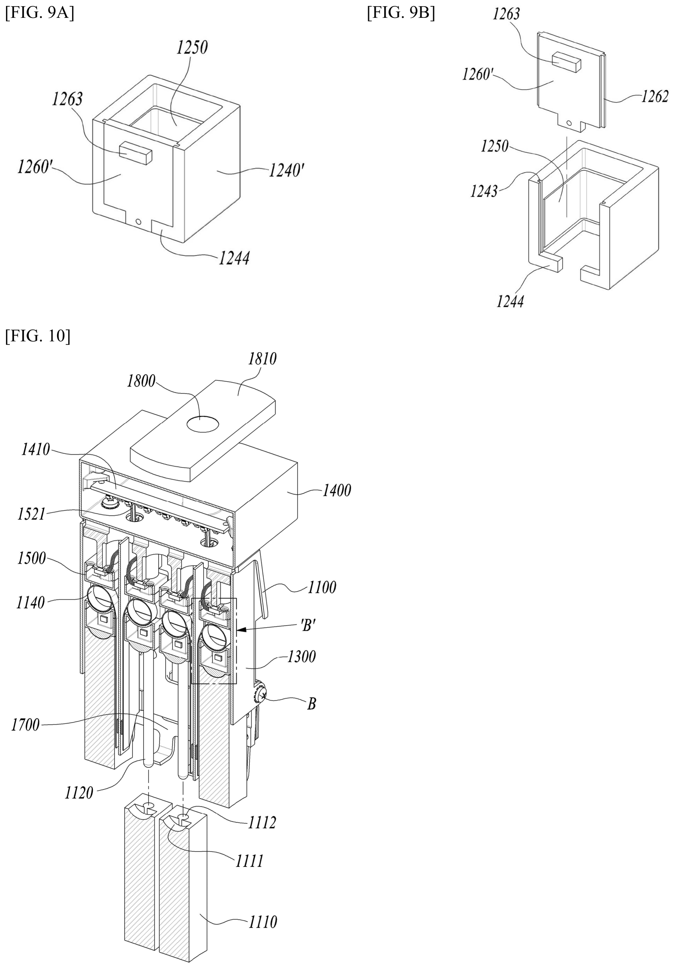

FIGS. 8A and 8B are perspective views showing a first embodiment of a sensor housing and a state in which a shielding plate is separated from the sensor housing. FIGS. 9A and 9B are perspective views showing a second embodiment of a sensor housing and a state in which the housing cover is separated from the sensor housing.

As shown in FIGS. 7, 8A, and 8B, according to an embodiment, the brush holder 1000 may further include a sensor housing 1240, a shielding plate 1250, and a housing cover 1260. The sensor housing 1240 may be formed in a hollow hexahedron, and specifically, may be formed in a "C"-shape in which an upper surface, a lower surface, and a first side surface of the hollow hexahedron are open. The sensor housing 1240 may be installed on the terminal bar 1210 such that the magnetic field sensor 1230 may be disposed inside the sensor housing 1240.

According to an embodiment, the sensor housing 1240 may be penetrated by the terminal bar 1210 in the vertical direction. The shielding plate 1250 may be installed at an inner side surface of the sensor housing 1240. As described above, since the plurality of brushes 1110 are arranged in a line on the body 1100, magnetic interference from adjacent terminal bars 1210 may occur.

Such magnetic interference may cause errors in magnetic field measurement. Accordingly, the shielding plate 1250 may block ambient magnetic field, thereby improving reliability of magnetic field measurement.

According to an embodiment, the shielding plate 1250 may be formed in a "C"-shaped configuration corresponding to the sensor housing 1240. The shielding plate 1250 may be disposed along the inner circumferential surface of the sensor housing 1240 to surround the terminal bar 1210.

According to an embodiment, a plate insertion groove 1241 may be formed on the inner side surface of the sensor housing 1240 so that the shielding plate 1250 may be inserted into the plate insertion groove. That is, as the shielding plate 1250 is inserted into the plate insertion groove 1241, an inner space for accommodating the terminal bar 1210, the magnetic field sensor 1230, and the housing cover 1260 may be secured. In addition, the sensor housing 1240 may be formed in a more compact configuration.

According to an embodiment, the housing cover 1260 may be formed in a plate shape. The housing cover 1260 may be selectively coupled to or separated from the sensor housing 1240 to open and close the sensor housing 1240. The housing cover 1260 may be coupled to opposite side ends of the sensor housing 1240 and may be disposed to face the magnetic field sensor 1230. The housing cover 1260 may also be fixed to the terminal bar 1210.

In the first embodiment, the sensor housing 1240 may be coupled to the housing cover 1260 using a hook structure. Hook protrusions 1242 may be formed at the opposite side ends of the sensor housing 1240 to be coupled to the housing cover 1260.

At the hook protrusion 1242, an inclined surface 1242a may be formed in a coupling direction of the housing cover 1260. Opposite side ends of the housing cover 1260 contact the inclined surfaces 1242a and may move along the inclined surfaces 1242a into the sensor housing 1240. The opposite side ends of the sensor housing 1240 may be elastically deformed outward by the housing cover 1260.

In addition, when the opposite side ends of the housing cover 1260 pass over the hook protrusions 1242, the force applied to the housing cover 1260 may be released, allowing the housing cover 1260 to elastically return to its original shape, with its side ends engaged by the hook protrusions 1242.

According to an embodiment, handle protrusions 1261 may be formed at the opposite side ends of the housing cover 1260. The handle protrusions 1261 may engage the opposite side ends of the sensor housing 1240. When the manager grips and pressurizes both handle protrusions 1261, the housing cover 1260 may elastically deform, thereby disengaging from the hook protrusions 1242 and allowing removal of the housing 1260.

As shown in FIGS. 7, 9A, and 9B, in the second embodiment, a sensor housing 1240' may be coupled to a housing cover 1260' in a sliding manner.

Slide grooves 1243 extending in the vertical direction may be formed at opposite side ends of the sensor housing 1240'. Coupling protrusions 1262 may be formed in the vertical direction at opposite side ends of the housing cover 1260' and may be inserted into the slide grooves 1243. The housing cover 1260' may be fixed to the terminal bar 1210.

A handle protrusion 1263 may be formed on a side surface of the housing cover 1260'. The manager may grip the handle protrusion 1263 to facilitate coupling or separation of the housing cover 1260' relative to the sensor housing 1240'.

According to an embodiment, support protrusions 1244 may be formed at lower portions of the opposite side ends of the sensor housing 1240' and may be in contact with a lower end of the housing cover 1260. The housing cover 1260 may be stably supported by contact with the support protrusions 1244.

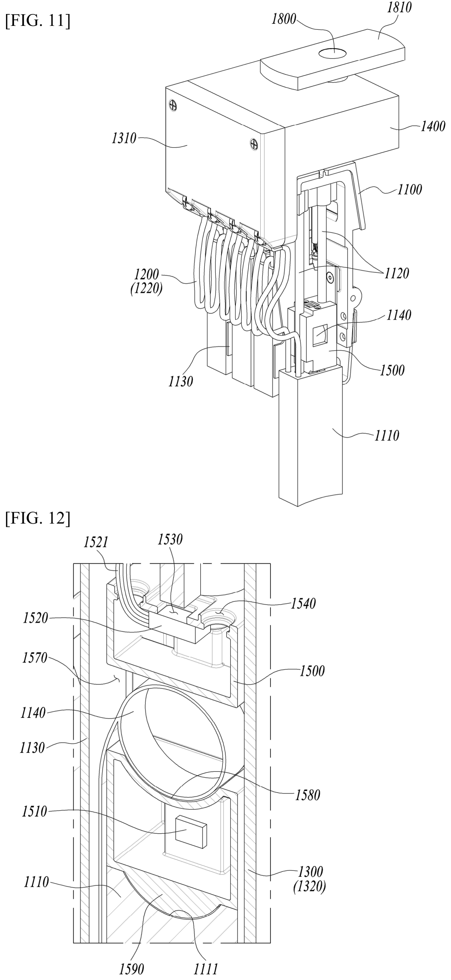

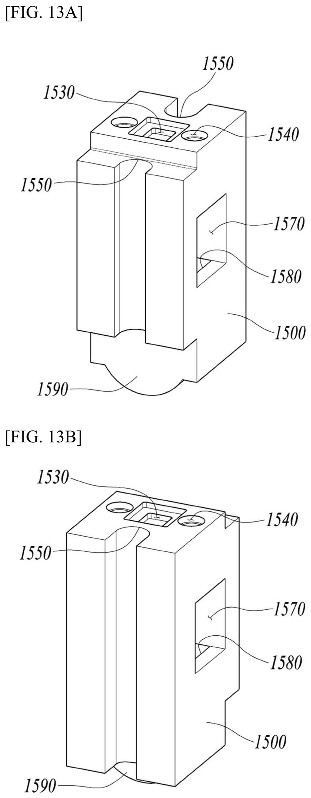

FIG. 10 is a sectional view taken along line B-B shown in FIG. 3. FIG. 11 is a perspective view showing a state in which a sensor block and the brush are lowered. FIG. 12 is an enlarged view of portion B shown in FIG. 10. FIGS. 13A and 13B are perspective views showing a first side surface and a second side surface of the sensor block.

As shown in FIGS. 10 to 13B, the controller housing 1400 may have a hollow hexahedral shape. For example, the controller housing 1400 may have a rectangular parallelepiped shape. The controller housing 1400 may be fixed to the upper surface of the body 1100, and a printed circuit board 1410 may be fixed inside the controller housing 1400. On the printed circuit board 1410, components related to the operation of the brush holder 1000, including a controller and a communication part, may be mounted.

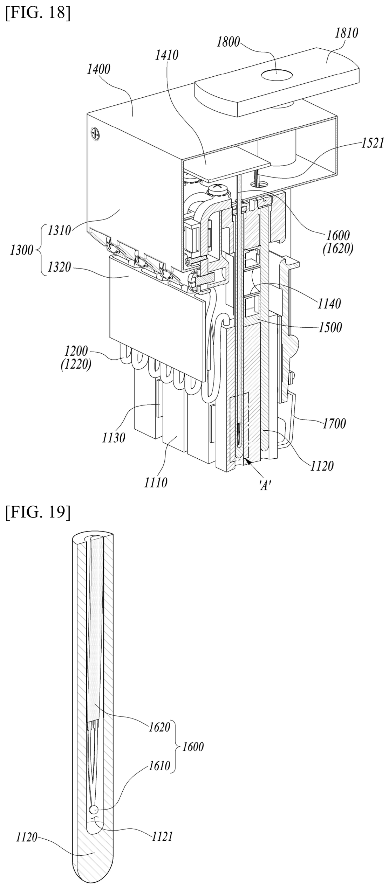

In addition, a first sensor wire 1521 and a second sensor wire 1620, which will be described later, may penetrate and pass through a lower surface of the controller housing 1400 and may be electrically connected to the printed circuit board 1410 (shown in FIG. 18). In addition, a magnetic field sensor 1230 (shown in FIG. 7) may be electrically connected to the printed circuit board 1410 via a wire.

The brush holder may further include a guide pin 1120, a sensor block 1500, a vibration sensor 1510, a distance sensor 1520, a partition plate 1130, and a roll spring 1140. The guide pin 1120 may fix the brush 1110 while allowing the brush 1110 to stably move in the vertical direction.

An upper end of the guide pin 1120 may be fixed to the body 1100. In the brush 1110, a pin insertion hole 1112 extending in the vertical direction may be formed. A lower portion of the guide pin 1120 may be inserted in the vertical direction into the pin insertion hole 1112 and may extend into the brush 1110.

According to an embodiment, the sensor block 1500 may have a hollow hexahedral shape, e.g., a rectangular parallelepiped shape. A pin through-hole 1550 extending in the vertical direction may be formed in the sensor block 1500 such that the guide pin 1120 passes through the sensor block. The sensor block 1500 may be penetrated and guided by the guide pin 1120 and may be disposed between the body 1100 and the brush 1110.

According to an embodiment, the sensor block 1500 may be provided with two pin through-holes 1550 and may be guided by two guide pins 1120.

According to an embodiment, the vibration sensor 1510 may be installed in the sensor block 1500 to measure vibration transmitted from the brush 1110. The distance sensor 1520 may be installed in the sensor block 1500 to measure the wear amount of the brush 1110. Herein, the wear amount of the brush 1110 may be defined as an amount of change in length of the brush 1110 during a predetermined time.

According to an embodiment, the distance sensor 1520 may operate using a laser output method. An opening hole 1530 may be formed in an upper surface of the sensor block 1500. The distance sensor 1520 may be installed at on inner upper surface of the sensor block 1500 and may be disposed at the opening hole 1530.

According to an embodiment, a laser output from the distance sensor 1520 may pass through the opening hole 1530 and reach the upper surface of the body 1100, thereby enabling measurement of a distance between the sensor block 1500 and the body 1100.

As the brush 1110 wears out and its length decreases, the distance between the sensor block 1500 and the body 1100 increases. The controller may calculate the wear amount of the brush 1110 based on a measurement value from the distance sensor 1520.

According to an embodiment, the vibration sensor 1510 may be fixed to an inner lower portion of the sensor block 1500. A lower end of the sensor block 1500 and the upper end of the brush 1110 may be maintained in contact with each other by the roll spring 1140. Accordingly, vibration of the brush 1110 may be directly transmitted to the vibration sensor 1510, thereby improving reliability of vibration measurement.

According to an embodiment, the controller may transmit measurement values of the distance sensor 1520 and the vibration sensor 1510 and the wear amount of the brush 1110 to the manager terminal so that the manager may monitor the state of the brush 1110 in real time. The manager may monitor the brush 1110 and selectively determine whether to replace the brush 1110 and/or whether to operate a generator based on the monitored information.

According to an embodiment, a connection protrusion 1590 may be formed at a lower surface of the sensor block 1500. A support groove 1111 may be formed in an upper surface of the brush 1110 and the connection protrusion 1590 may be inserted into the support groove. Accordingly, the contact between the sensor block 1500 and the brush 1110 may be more securely maintained through the structure of the connection protrusion 1590 and the support groove 1111. In addition, the vibration of the brush 1110 may be transmitted to the sensor block 1500 with reduced dispersion, thereby further improving reliability of vibration measurement.

The distance sensor 1520 and the vibration sensor 1510 may be electrically connected to the printed circuit board 1410 via the first sensor wire 1521. A block wiring hole 1540 may be formed in the upper surface of the sensor block 1500 to allow the first sensor wire 1521 to pass through the block wiring hole. According to an embodiment, the magnetic field sensor 1230 (shown in FIG. 7), the distance sensor 1520, and the vibration sensor 1510 may be electrically connected to the controller and/or the manager terminal in wirelessly rather than through a wired connection.

According to an embodiment, the partition plate 1130 is an element for supporting the roll spring 1140. The partition plate 1130 may be fixed to a side surface of the body 1100 and may be disposed to face a side surface of the brush 1110. The roll spring 1140 may be fixedly disposed between the partition plate 1130 and the sensor block 1500 to lower the sensor block 1500.

As the roll spring 1140 is rolled, the sensor block 1500, the brush 1110, and the collector ring 12 (shown in FIG. 2) may be continuously maintained in sequentially contact with one another by the elastic force of the roll spring 1140.

A spring insertion hole 1570 may be formed in a side surface of the sensor block 1500 so that an upper portion of the roll spring 1140 having a cylindrical shape may be inserted into the spring insertion hole. A spring mounting groove 1580 may be formed in an inner lower surface of the sensor block 1500.

The upper portion of the roll spring 1140 may be seated in the spring mounting groove 1580 and may be retained by the sensor block 1500. The spring mounting groove 1580 may be formed in a semi-circular shape to correspond to an outer circumferential shape of the roll spring 1140.

According to an embodiment, the sensor block 1500 may include two chamber - an upper chamber and a lower chamber. The distance sensor 1520 may be disposed in the upper chamber and the vibration sensor 1510 may be disposed in the lower chamber. The rolled portion of the rolling spring 1140 may be disposed between the upper chamber and the lower chamber. The spring mounting groove 1580 may be formed in an upper support of the lower chamber.

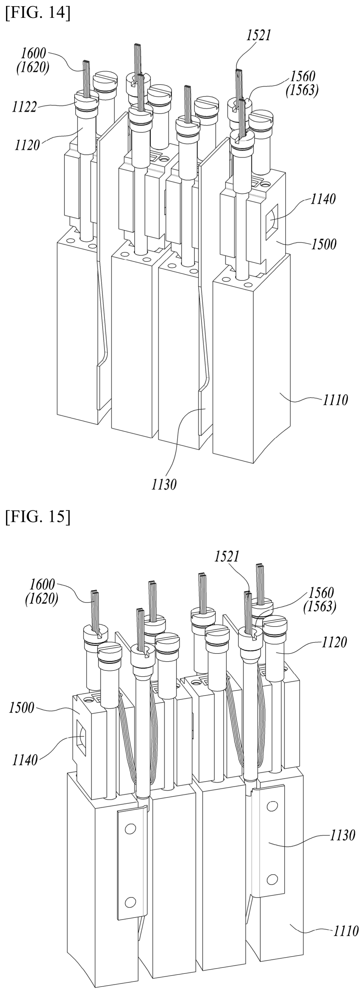

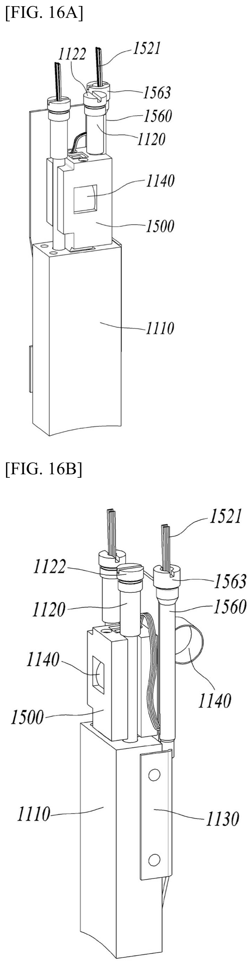

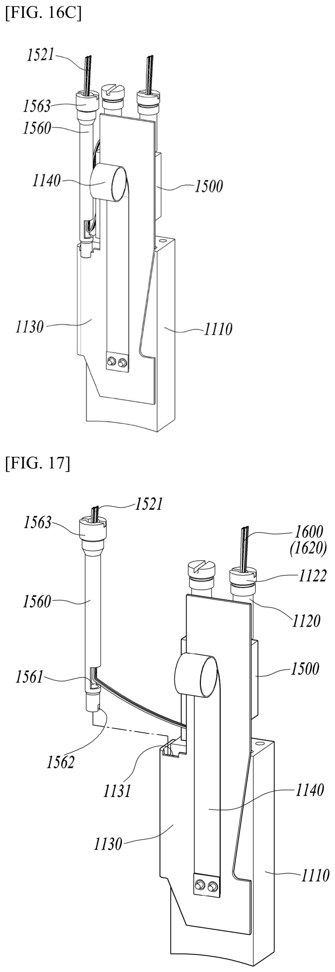

FIG. 14 is a perspective view showing a first side of a plurality of sensor blocks and brushes. FIG. 15 is a perspective view showing a second side of the plurality of sensor blocks and brushes. FIGS. 16A to 16C are perspective views showing a first side surface, a rear surface, and a second side surface of a single sensor block and a single brush. FIG. 17 is a perspective view showing a state in which a wiring duct is separated from the partition plate.

As shown in FIGS. 14 to 17, according to an embodiment, the brush holder 1000 may further include a wiring duct 1560. The wiring duct 1560 is an element for protecting the first sensor wire 1521. The wiring duct 1560 may extend in a vertical direction from an upper end of the partition plate 1130 such that the first sensor wire 1521 passes through the wiring duct 1560.

A wiring-duct-side fixing groove 1562 may be formed at a lower end of the wiring duct 1560. A partition-plate-side fixing groove 1131 may be formed at the upper end of the partition plate 1130 and may engage with the wiring-duct-side fixing groove 1562 to secure the wiring duct 1560 to the partition plate 1130.

A duct wiring hole 1561 may be formed in a circumferential surface of a lower portion of the wiring duct 1560 so that the first sensor wire 1521 coming out of the sensor block 1500 may pass through the wiring duct 1560 through the duct wiring hole 1561. A wiring duct cap 1563 may be fitted onto an upper end of the wiring duct 1560 so that the wiring duct 1560 may be kept airtight.

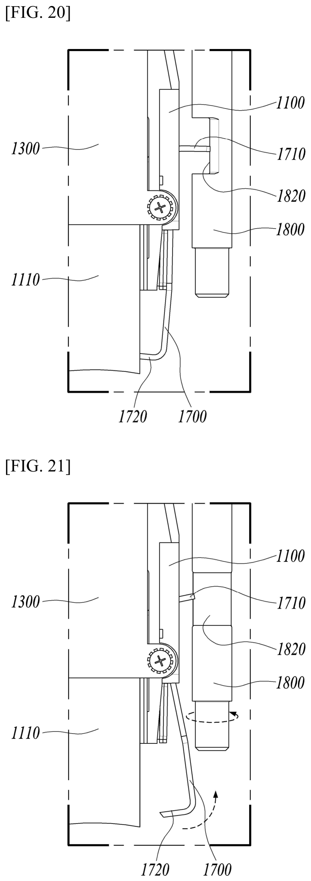

FIG. 18 is a sectional view taken along line A-A shown in FIG. 3. FIG. 19 is an enlarged view of portion A shown in FIG. 18. FIG. 20 is a side view showing a state in which the brush is fixed to a hook member. FIG. 21 is a side view showing a state in which the brush is separated from the hook member.

As shown in FIGS. 18 to 21, according to an embodiment, the brush holder may further include a temperature sensor 1600. A thermocouple may be used as the temperature sensor 1600. A junction 1610 may be formed at a lower end of the thermocouple to measure the temperature of the brush 1110. The junction 1610 may be electrically connected to the printed circuit board 1410 via the second sensor wire 1620.

The temperature sensor 1600 may be installed at the guide pin 1120. A hollow portion 1121 extending in the vertical direction may be formed inside the guide pin 1120. The temperature sensor 1600 may be disposed with in the hollow portion 1121. According to an embodiment, the lower end of the hollow portion 1121 may be closed.

Accordingly, the junction 1610 is disposed inside the brush 1110 to directly measure the temperature of the brush 1110, thereby improving the reliability of temperature measurement. The controller may transmit a measurement value of the temperature sensor 1600 to the terminal or an eternal terminal so that the manager may monitor the state of the brush 1110 in real time.

The manager may monitor the brush 1110 and selectively determine whether to replace the brush 1110 and/or whether to operate a generator based on the monitored information. A guide pin cap 1122 may be fitted onto the upper end of the guide pin 1120 to maintain airtightness of the guide pin 1120.

The brush holder may further include a hook member 1700, a fixing rod 1800, and a handle 1810. The hook member 1700 may be formed in a plate shape. The hook member 1700 may be fixed to a side surface of the body 1100. The fixing rod 1800 may extend and penetrate through the controller housing 1400 in the vertical direction.

The fixing rod 1800 may selectively press the hook member 1700 to fix the hook member 1700 to the brush 1110 or separate the hook member from the brush 1110. The handle 1810 may be formed in a plate or block shape. The handle 1810 may be fixed to an upper end of the fixing rod 1800 to facilitate rotation of the fixing rod 1800.

A pressing protrusion 1710 may be formed at an upper end of the hook member 1700 and may extend toward the fixing rod 1800. At a lower end of the hook member 1700, a claw 1720 may be formed and extend toward the brush 1110. A protrusion insertion groove 1820 may be formed in an outer circumferential surface of the fixing rod 1800 so that the pressing protrusion 1710 may be selectively inserted into the protrusion insertion groove.

When the fixing rod 1800 rotates in a first direction (e.g., forward direction), the pressing protrusion 1710 may be withdrawn from the protrusion insertion groove 1820 and the fixing rod 1800 may press the pressing protrusion 1710 such that the claw 1720 is separated from a side surface of the brush 1110. When the fixing rod 1800 rotates in a second (i.e., opposite) direction (e.g., backward direction), the pressing protrusion 1710 may be guided into the protrusion insertion groove 1820 and the claw 1720 may return to its original position and engage the side surface of the brush 1110.

Accordingly, the brush 1110 may be fixed to the hook member 1700 to prevent unintentional separation of the brush 1150 from the body 1100. The manager may thereby transport the brush holder 1000 in a stable state while the brush 1110 is fixed to the body 1100, when coupling the brush holder to the busbar 13 (shown in FIG. 2) or separating the brush holder 1000 from the busbar 13.

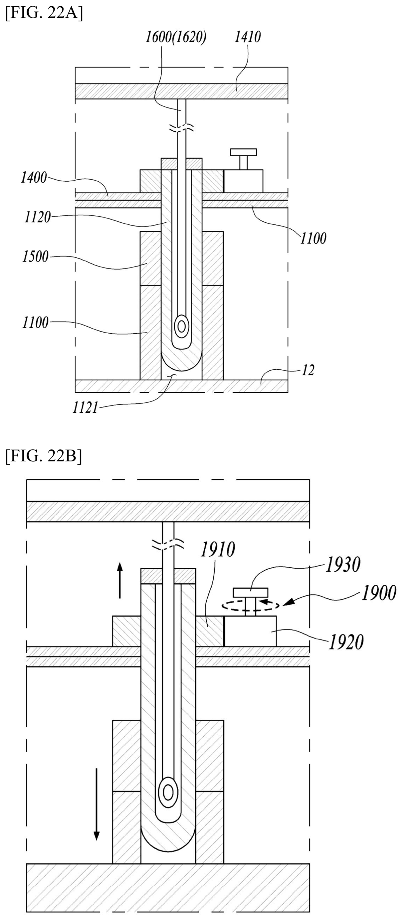

FIGS. 22A and 22B are schematic cross-sectional views showing an elevating part in the brush holder according to a second embodiment of the present disclosure and a state in which the guide pin is raised.

The brush holder according to the second embodiment of the present disclosure may have substantially the same structure as the brush holder according to the first embodiment except for an elevating part 1900. Accordingly, redundant descriptions of the same elements will be omitted.

As shown in FIGS. 22A and 22B, the brush holder may further include the elevating part 1900. The elevating part 1900 may selectively raise or lower the guide pin 1120. In this embodiment, unlike the above-described first embodiment, an upper portion of the guide pin 1120 may extend through the upper surface of the body 1100 and the lower surface of the controller housing 1400.

As the brush 1110 wears and its length decreases, the distance between the collector ring 12 and the guide pin 1120 may also decrease. If this condition continues, the lower end of the guide pin 1120 may come into contact with the collector ring 12, which may result in component damage and an increased risk of a fire. Meanwhile, as the distance between the lower end of the guide pin 1120 and the collector ring 12 becomes shorter, the frictional heat generated between the brush 1110 and the collector ring 12 may be measured more accurately.

The controller may drive the elevating part 1900 based on a measurement value of the distance sensor to selectively raise or lower the guide pin 1120. Accordingly, the distance between the lower end of the guide pin 1120 and the collector ring 12 may be maintained at a predetermined minimum value, thereby reducing the possibility of component damage and improving reliability of temperature measurement.

According to an embodiment, the elevating part 1900 may include a coupling ring 1910, a gear 1920, and a motor 1930. The upper portion of the guide pin 1120 may be disposed inside the controller housing 1400. The coupling ring 1910 may also be disposed inside the controller housing 1400 and may be rotatably supported therein.

According to an embodiment, screw threads may be formed at an outer circumferential surface and an inner circumferential surface of the coupling ring 1910. The guide pin 1120 may extend through the coupling ring 1910 and may be screw-coupled to the coupling ring 1910.

The gear 1920 may be engaged with teeth formed on the outer circumferential surface of the coupling ring 1910. An electric motor may be used as the motor 1930. A rotation shaft of the motor 1930 may be fixed to the gear 1920 to rotate the gear 1920.

Accordingly, the rotational force of the motor 1930 may be converted into a linear motion by the threaded engagement between the coupling ring 1910, thereby raising or lowering the guide pin 1120.

Although an embodiment of the present disclosure has been described above, those skilled in the art will understand that various modifications and changes may be made to the present disclosure by adding, changing, deleting, or supplementing elements without departing from the idea of the present disclosure as set forth in the claims, and such modifications and changes are also included within the scope of the present disclosure.

## Claims

1. A brush holder, comprising:
a body having a lower side configured to mount a brush;
a connection part operable to connect the body to the brush to transfer current from the body to the brush;
a magnetic field sensor installed at the connection part to measure a magnetic field of the connection part; and
a controller configured to calculate an amount of current flowing through the brush based on a measurement value of the magnetic field sensor.

2. The brush holder of claim 1, wherein the controller is configured to transmit, to an external terminal, the measurement value of the magnetic field sensor or the amount of current.

3. The brush holder of claim 1 or 2, wherein the connection part comprises:
a terminal bar having an upper portion installed at the body, and a side surface at which the magnetic field sensor is disposed; and
an electric wire installed at a lower portion of the terminal bar and configured to be connected to the brush.

4. The brush holder of claim 3, further comprising:
a sensor housing installed at the terminal bar so that the magnetic field sensor is disposed inside the sensor housing; and
a shielding plate installed at the sensor housing.

5. The brush holder of claim 4, further comprising a housing cover detachably coupled with the sensor housing.

6. The brush holder of claim 5, wherein the housing cover is coupled to opposite side ends of the sensor housing to face the magnetic field sensor.

7. The brush holder of claim 4, 5 or 6, wherein the shielding plate is installed at an inner side surface of and along a circumference of the sensor housing to surround the terminal bar.

8. The brush holder of any one of the preceding claims 4-7, wherein a plate insertion groove is formed in an inner side surface of the sensor housing so that the shielding plate is inserted into the plate insertion groove.

9. The brush holder of any one of the preceding claims 5-8, wherein hook protrusions are formed at opposite side ends of the sensor housing to be coupled to the housing cover.

10. The brush holder of any one of the preceding claims 5-9, wherein handle protrusions are formed at opposite side ends of the housing cover.

11. The brush holder of any one of the preceding claims 5-10, wherein slide grooves are formed extending in a vertical direction at opposite side ends of the sensor housing, and
coupling protrusions are formed extending in the vertical direction at opposite side ends of the housing cover to be inserted into the slide grooves.

12. The brush holder of claim 11, wherein support protrusions are formed at the opposite side ends of the sensor housing to be in contact with a lower end of the housing cover.

13. The brush holder of any one of the preceding claims 3 - 12, further comprising a body cover installed at the body to cover the electric wire.

14. The brush holder of claim 13,
wherein the electric wire includes a plurality of wires,
wherein a plurality of partition walls are formed on a side surface of the body cover and are spaced apart from each other, and
wherein each of the plurality of electric wires is disposed between two adjacent partition walls from among the plurality of partition walls such that the plurality of partition walls separates each wire from other wires from among the plurality of wires.

15. A brush holder rigging, comprising:
a rotor of a generator;
a collector ring penetrated by the rotor and fixed to the rotor;
a busbar penetrated by the collector ring;
a brush in contact with the collector ring; and
a brush holder coupled to the busbar,
wherein the brush holder comprises:
a body having a lower side configured to mount the brush;
a connection part operable to connect the body to the brush to transfer current from the body to the brush;
a magnetic field sensor installed at the connection part to measure a magnetic field of the connection part; and
a controller configured to calculate an amount of current flowing through the brush based on a measurement value of the magnetic field sensor.
